# EUROPEAN PATENT APPLICATION

(11) **EP 4 368 788 A1**
(43) Date of publication of application: **15.05.2024**
(21) Application number: 23202925.6
(22) Date of filing: 11.10.2023
(51) Int. Cl.: E04B 1/348, E04C 2/32, H01M 50/202, H01M 50/224, H01M 50/24, H01M 50/251

(54) **CABINET UNIT AND CABINET SYSTEM**

(30) Priority: 08.11.2022 TW 111142615
(71) Applicant: TCC Energy Storage Technology Corporation, Taipei City 104414 (TW)
(72) Inventor: CHANG, An-Ping, 104414 TAIPEI CITY (TW)
(74) Representative: 2K Patentanwälte Blasberg Kewitz & Reichel

(57) **Abstract**

The present disclosure provides a cabinet unit and a cabinet system. The cabinet unit includes a plurality of side walls consisting of a plurality of side wall units. A plurality of cabinet units are connected to one another to form the cabinet system.

## Description

### BACKGROUND OF THE INVENTION

### 1. Field of the Invention

The present disclosure substantially relates to a cabinet unit and a cabinet system. More specifically, the present disclosure relates to a cabinet unit constructed with side wall structure having extrusion and a cabinet system formed by connecting a plurality of cabinet units.

### 2. Description of the Related Art

In order to improve the efficiency and flexibility of use of energy, the development of energy storage equipment has become a trend in recent years. With the development and maturity of battery technology (such as lithium batteries), battery energy storage equipment have become one of the mainstream energy storage equipment. Considering the convenience for loading and transportation and weather resistance, metal containers commonly used in international shipping are currently used as energy storage cabinets for energy storage equipment.

However, during storage or transportation of the batteries, the separator in the battery may be damaged due to various factors (e.g., overcharge, impact, electronic control system error, operating environment or process defects), so that the cathode comes into contact with the anode to form a short circuit, which may result in a high-temperature chemical reaction and thus ignite combustible organic constituents in the battery. The high temperature generated by thermal runaway of the battery may further lead to the damage of devices adjacent to the battery energy storage device and the occurrence of fire accidents.

In addition, in order to achieve the objective of convenient loading, transportation and assembly, energy storage cabinets that can be constructed by assembling multiple individual components are expected by the industry.

### SUMMARY OF THE INVENTION

In one or more embodiments, a cabinet unit includes at least one side wall, having a first side wall unit and a second side wall unit adjacent to the first side wall unit. A first side surface of the first side wall unit has a first fitting piece. A second side surface of the second side wall unit corresponding to the first side surface of the first side wall unit has a second fitting piece. The first fitting piece and the second fitting piece are configured to be fitted with one another.

In one or more embodiments, a cabinet system includes a plurality of cabinet units connected to one another. There is a middle wall between any adjacent two of the plurality of cabinet units. The middle wall has a third side wall unit and a fourth side wall unit adjacent to the third side wall unit. A third side surface of the third side wall unit has a third fitting piece. A fourth side surface of the fourth side wall unit corresponding to the third side surface of the third side wall unit has a fourth fitting piece. The third fitting piece and the fourth fitting piece are configured to be fitted with one another.

### BRIEF DESCRIPTION OF THE DRAWINGS

When the present disclosure is read in conjunction with the accompanying drawings, aspects of the present disclosure can be better understood according to the following implementations. It should be noted that various features may not be drawn to scale, and the dimensions of various features may be arbitrarily enlarged or reduced in order to clearly describe the present disclosure.
FIG. 1 shows a perspective view of a cabinet unit according to some embodiments of the present disclosure;
FIG. 2 shows a top perspective view of the cabinet unit according to some embodiments of the present disclosure;
FIG. 3 shows a side sectional view of the cabinet unit according to some embodiments of the present disclosure;
FIG. 4 shows a sectional view of a door and part of a top plate and a bottom plate of the cabinet unit according to some embodiments of the present disclosure;
FIG. 5 shows a detailed enlarged view of part A in FIG. 2;
FIG. 6 shows a detailed enlarged view of part B in FIG. 2;
FIG. 7 shows a detailed enlarged view of part C in FIG. 3;
FIG. 8 shows a sectional view of FIG. 3 taken along line 4-4;
FIG. 9 shows a detailed enlarged view of part D in FIG. 2;
FIG. 10 shows a detailed enlarged view of part E in FIG. 4;
FIG. 11 shows a detailed enlarged view of part F in FIG. 4;
FIG. 12 shows a detailed enlarged view of part G in FIG. 3;
FIG. 13 shows a sectional view of FIG. 3 taken along line 8-8;
FIG. 14 shows a perspective view of a cabinet system according to some embodiments of the present disclosure;
FIG. 15 shows a top perspective view of the cabinet system according to some embodiments of the present disclosure;
FIG. 16 shows a side sectional view of the cabinet system according to some embodiments of the present disclosure;
FIG. 17 shows a detailed enlarged view of part H in FIG. 15;
FIG. 18 shows a detailed enlarged view of part I in FIG. 15;
FIG. 19 shows a detailed enlarged view of part J in FIG. 16;
FIG. 20 shows a detailed enlarged view of part K in FIG. 16;
FIG. 21 shows a sectional view of another embodiment of a fitting piece of the present disclosure;
FIG. 22 shows a sectional view of another embodiment of a fitting piece of the present disclosure;
FIG. 23 shows a sectional view of another embodiment of a fitting piece of the present disclosure;
FIG. 24 shows a sectional view of another embodiment of a fitting piece of the present disclosure;
FIG. 25 shows a sectional view of another embodiment of a fitting piece of the present disclosure;
FIG. 26 shows a sectional view of another embodiment of a fitting piece of the present disclosure;
FIG. 27 shows a sectional view of another embodiment of a fitting piece of the present disclosure;
FIG. 28 shows a sectional view of another embodiment of a fitting piece of the present disclosure;
FIG. 29 shows a sectional view of another embodiment of a fitting piece of the present disclosure;
FIG. 30 shows a sectional view of another embodiment of a fitting piece of the present disclosure;
FIG. 31 shows a sectional view of another embodiment of a fitting piece of the present disclosure;
FIG. 32 shows a sectional view of another embodiment of a fitting piece of the present disclosure;
FIG. 33 shows a sectional view of another embodiment of a fitting piece of the present disclosure;
FIG. 34 shows a sectional view of another embodiment of a fitting piece of the present disclosure; and
FIG. 35 shows a sectional view of another embodiment of a fitting piece of the present disclosure.

In the drawings and implementations of the present disclosure, the same or similar components are denoted by the same component symbols.

### PREFERRED EMBODIMENT OF THE PRESENT INVENTION

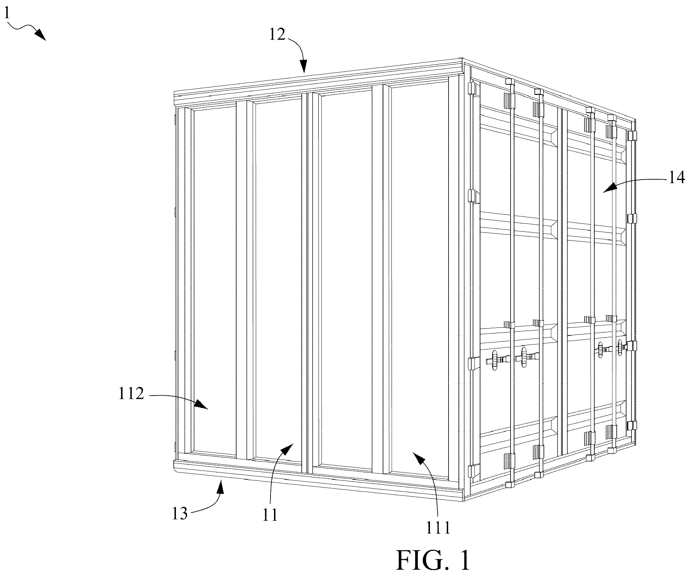

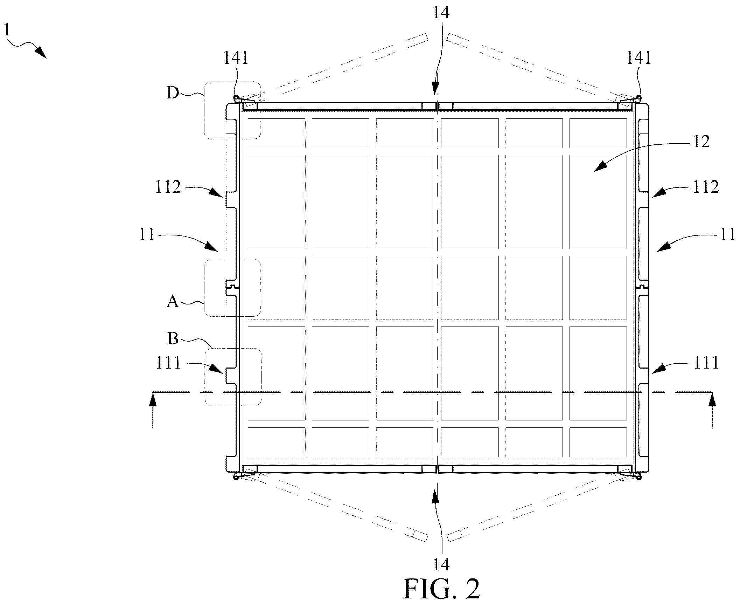

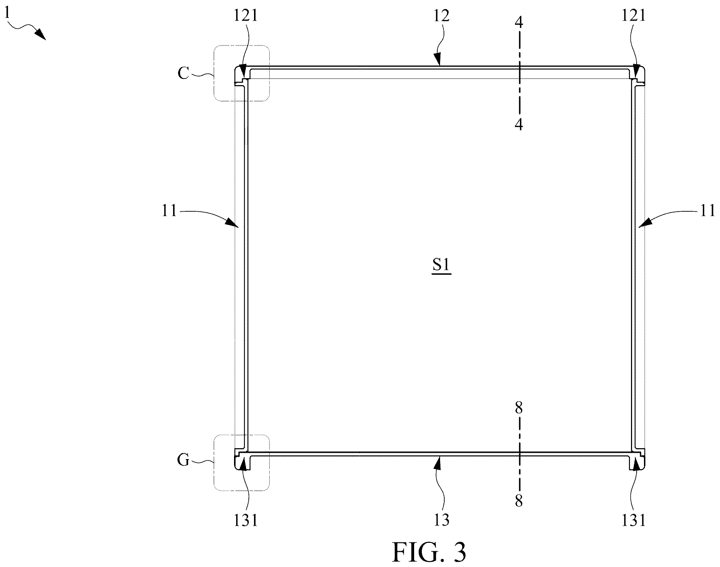

FIG. 1 shows a schematic perspective view of a cabinet unit according to some embodiments of the present disclosure. FIG. 2 shows a top perspective view of the cabinet unit according to some embodiments of the present disclosure. In some embodiments, FIG. 3 shows a side sectional view of the cabinet unit according to some embodiments of the present disclosure.

The cabinet unit 1 may include a plurality of side surfaces, a top plate 12 and a bottom plate 13 to form an accommodating space S1. In some embodiments, part of the plurality of surfaces (e.g., two opposite side surfaces) may be provided with side walls 11, and the remaining side surface may be provided with a door 14. In some embodiments, the size of the accommodating space S1 may allow an operator to enter therein, so that functional components or devices arranged in the accommodating space S 1 can be maintained and/or operated. In some embodiments, as shown in FIG. 1, FIG. 2 and FIG. 3, the side wall 11, the top plate 12 and the bottom plate 13 have a plate-like structure. In some embodiments, outer surfaces of the side wall 11, the top plate 12 and the bottom plate 13 are substantially flat surfaces. In some embodiments, one or more of the side wall 11, the top plate 12 and the bottom plate 13 may also have a non-plate-like structure. For example, the outer surfaces of one or more of the side wall 11, the top plate 12 and the bottom plate 13 may have a special three-dimensional appearance, such as a wave-shaped structure, a hole structure, a groove structure, a protruding rib structure or a three-dimensional appearance of any other shape.

In the embodiment shown in FIG. 1, FIG. 2 and FIG. 3, the cabinet unit 1 is an independent structure. The detailed structure of the cabinet unit 1 of the present disclosure is described below.

In some embodiments, the side wall 11 of the cabinet unit 1 includes a first side wall unit 111 and a second side wall unit 112 adjacent to the first side wall unit 11. The first side wall unit 111 and the second side wall unit 112 may jointly form the side wall 11. In some embodiments, the side wall 11 of the cabinet unit 1 may be formed by connecting a plurality of side wall units to one another.

In some embodiments, the top plate 12 and the bottom plate 13 of the cabinet unit 1 are substantially rectangular, or may have other geometric shapes according to needs. In some embodiments, the top plate 12 and the bottom plate 13 may be square, circular or triangular, or other geometric shapes as needed. In some embodiments, the side wall 11 is substantially rectangular. In some embodiments, the side wall 11 may have any shape suitable to be fitted with the top plate 12 and the bottom plate 13.

In some embodiments, the bottom plate 13 is rectangular, and two side walls 11 of the cabinet unit 1 are respectively arranged on two opposite peripheral sides 131 of an upper surface of the bottom plate 13. In some embodiments, the top plate 12 is rectangular, and two side walls 11 of the cabinet unit 1 are respectively arranged on two opposite peripheral sides 121 of a lower surface of the top plate 12. In some embodiments, top surfaces and bottom surfaces of the two side walls 11 of the cabinet unit 1 are respectively fastened to the peripheral sides 121 on the lower surface of the top plate 12 and the peripheral sides 131 on the upper surface of the bottom plate 13 (for example, by bolting, riveting, welding, snap-fit or the like).

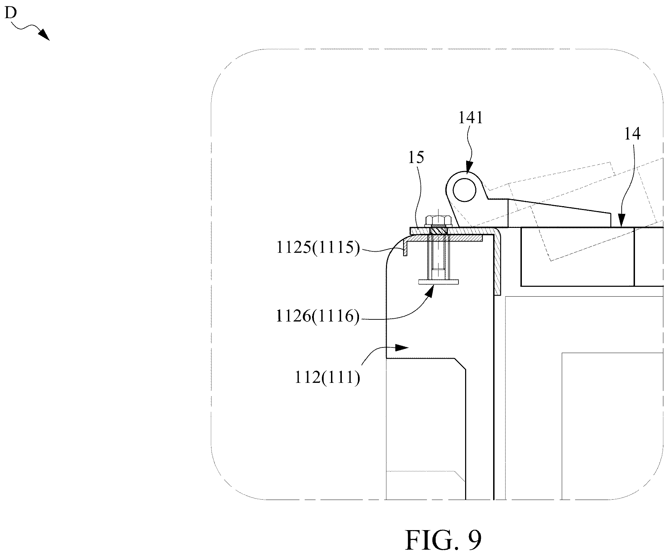

Referring to FIG. 3, in some embodiments, each of the other two side surfaces of the cabinet unit 1 is provided with a door 14. Referring to FIG. 9, in some embodiments, a side surface of the side wall 11 of the cabinet unit 1 is provided with a connector 15. In some embodiments, the connector 15 is provided with a hinge 141. In some embodiments, the door 14 is a double-leaf door, and a side surface of each leaf is connected to the hinge 141.

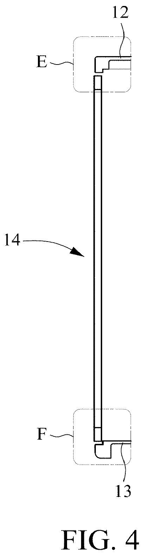

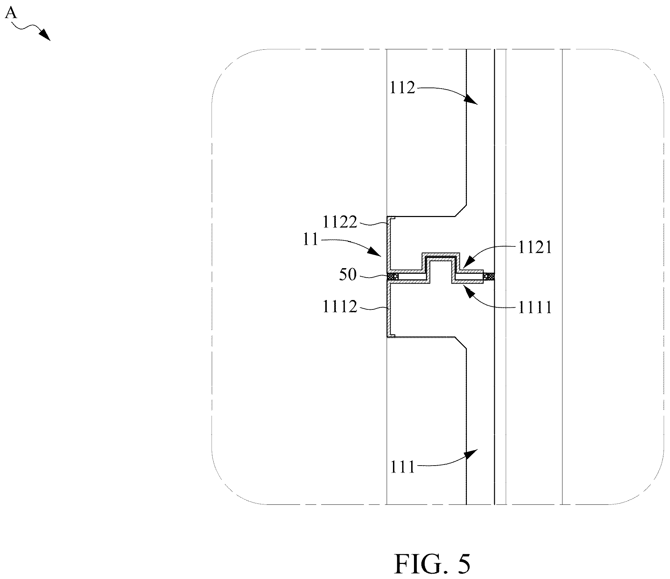

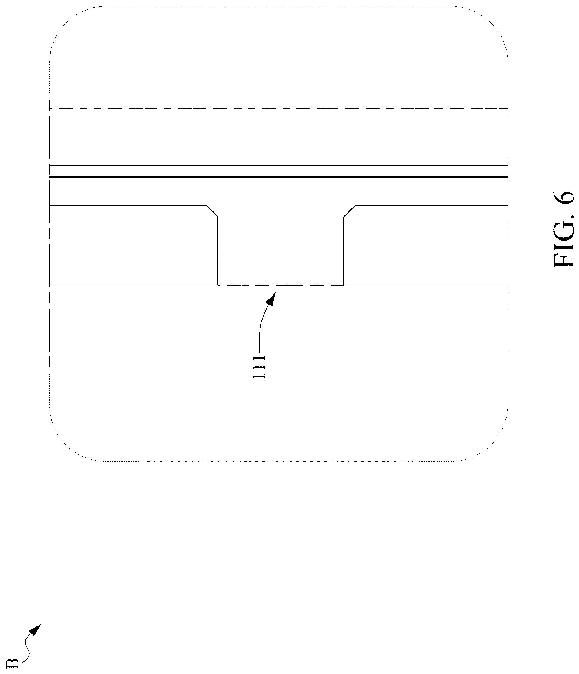

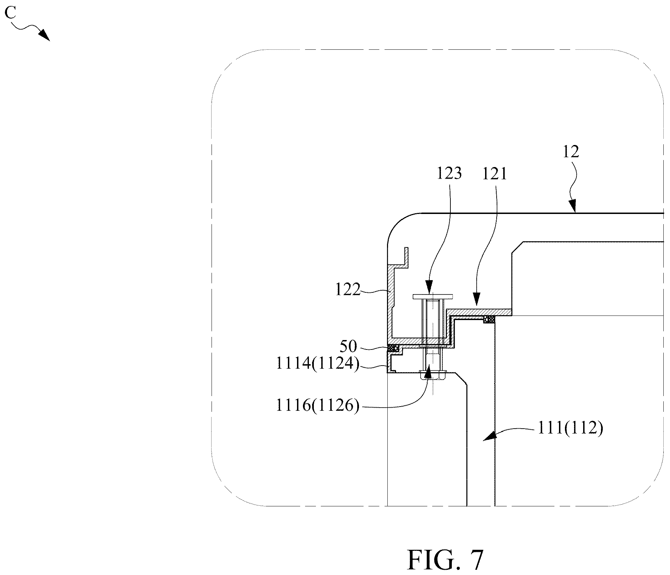

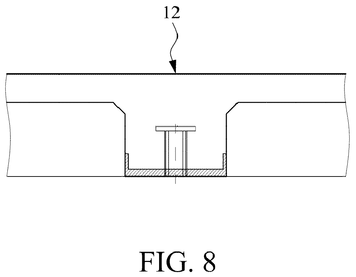

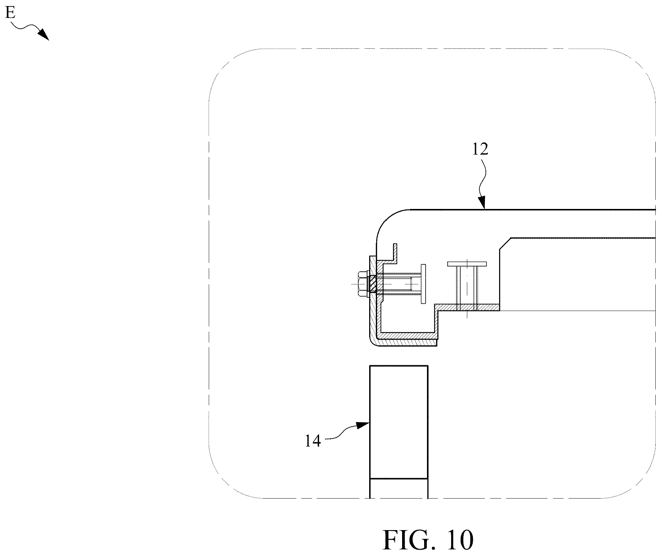

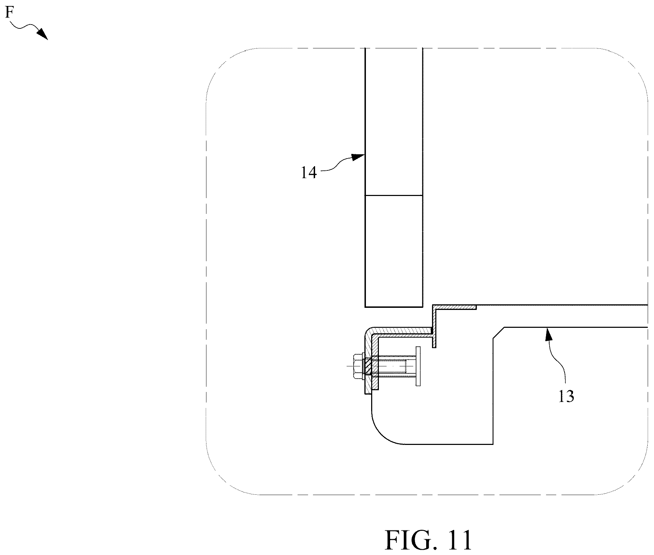

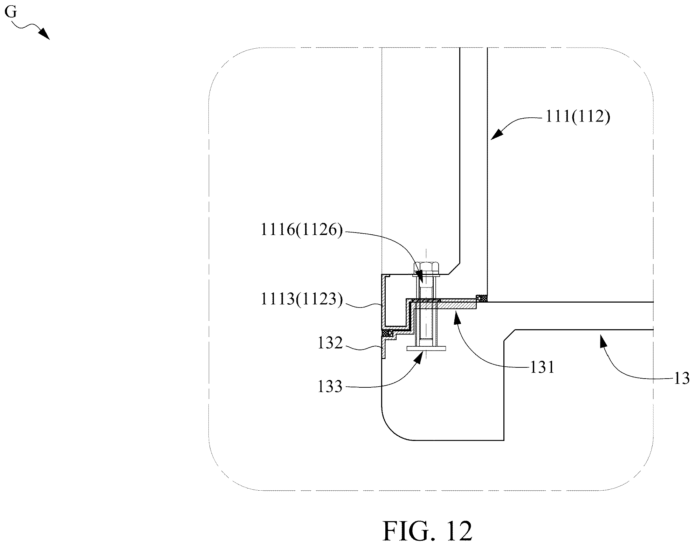

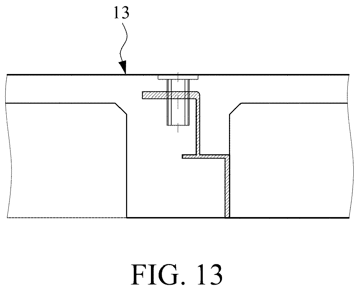

FIG. 5 to FIG. 13 are partially enlarged views of the cabinet unit 1 in FIG. 2 to FIG. 4. Detailed connection methods of the side walls 11, the top plate 12, the bottom plate 13 and the door 14 of the cabinet unit 1 of the present disclosure are described below. FIG. 7 and FIG. 12, which are partially enlarged views of C and G in FIG. 3, show detailed structures of the connections of the first side wall unit 111 with the top plate 12 and the bottom plate 13. FIG. 9 shows a detailed structure of the connection of the first side wall unit 111 with the door 14 on one side of the cabinet unit. Also refereeing to FIG. 7, FIG. 9 and FIG. 12The connection methods of the second side wall unit 112 with the top plate 12, the bottom plate 13 and the door 14 are similar to those of the first side wall unit 111.

Referring to FIG. 5, in some embodiments, the first side wall unit 111 of the side wall 11 of the cabinet unit 1 has a first fitting piece 1112 on a first side surface 1111. Referring to FIG. 12, a side surface of the first side wall unit 111 facing the bottom plate 13 has a fitting piece 1113. Referring to FIG. 7, a side surface of the first side wall unit 111 facing the top plate 12 has a fitting piece 1114. Referring to FIG. 9, a vertical outer side surface of the first side wall unit 111 has a fitting piece 1115.

Referring to FIG. 5, in some embodiments, the second side wall unit 112 of the side wall 11 of the cabinet unit 1 has a second fitting piece 1122 on a second side surface 1121. Referring to FIG. 12, a side surface of the second side wall unit 112 facing the bottom plate 13 has another fitting piece 1123. Referring to FIG. 7, a side surface of the second side wall unit 112 facing the top plate 12 has a fitting piece 1124. Referring to FIG. 9, a vertical outer side surface of the second side wall unit 112 has a fitting piece 1125.

In some embodiments, the first side wall unit 111 and the second side wall unit 112 are made by concrete grouting. The first fitting piece 1112 and the fitting pieces 1113 to 1115 of the first side wall unit 111 and the second fitting piece 1122 and the fitting pieces 1123 to 1125 of the second side wall unit 112 are used as a part of a mold plate of concrete grouting. In some embodiments, after the concrete is poured and solidifies, the first fitting piece 1112 and the fitting pieces 1113 to 1115 of the first side wall unit 111 and the second fitting piece 1122 and the fitting pieces 1123 to 1125 of the second side wall unit 112 are not removed but left on the surfaces of the first side wall unit 111 and the second side wall unit 112, so that the first side surface 1111 of the first side wall unit 111 is defined by the first fitting piece 1112, and the second side surface 1121 of the second side wall unit 112 is defined by the second fitting piece 1122. In some embodiments, the fitting pieces 1113 to 1115 and 1123 to 1125 of the first side wall unit 111 and the second side wall unit 112 define their corresponding side surfaces.

In some embodiments, the first fitting piece 1112, the second fitting piece 1122, and the fitting pieces 1113 to 1115 and 1123 to 1125 are an extrusion, and preferably an aluminum extrusion. In some embodiments, the extrusion may be made of metal, such as stainless steel, iron or alloy. In some embodiments, the extrusion may be made of polymer, such as plastic, rubber or silicone.

Referring to FIG. 5, the first fitting piece 1112 of the first side wall unit 111 matches the second fitting piece 1122 of the second side wall unit 112. In some embodiments, the first fitting piece 1112 of the first side wall unit 111 and the second fitting piece 1122 of the second side wall unit 112 are configured to snap fit with each other. In some embodiments, the first fitting piece 1112 of the first side wall unit 111 and the second fitting piece 1122 of the second side wall unit 112 may also be connected to each other by welding, screwing, riveting or bonding. In some embodiments, a cross section of the first fitting piece 1112 has a male shape. A cross section of the second fitting piece 1122 has a female shape matching the male shape. In some embodiments, the cross section of the first fitting piece 1112 has a female shape. The cross section of the second fitting piece 1122 has a male shape matching the female shape.

Referring to FIG. 2 and FIG. 5, the side wall 1 is formed by the first fitting piece 1112 of the first side wall unit 111 and the second fitting piece 1122 of the second side wall unit 112 abutting against each other. In some embodiments, the male shape of the cross section of the first fitting piece 1112 fit with the female shape of the cross section of the second fitting piece 1122 to form the side wall 1.

Referring to FIG. 7, the peripheral side 121 of the top plate 12 has a fitting piece 122. Referring to FIG. 12, the peripheral side 131 of the bottom plate 13 has a fitting piece 132. In some embodiments, surfaces of the fitting piece 122 of the peripheral side 121 of the top plate 12 and the fitting piece 1114 of the first side wall unit 111 have shapes matching each other. In some embodiments, surfaces of the fitting piece 132 of the peripheral side 131 of the bottom plate 13 and the fitting piece 1113 of the first side wall unit 111 have shapes matching each other.

The structure shown in FIG. 7 may also illustrate the structural details of the connections of the second side wall unit 112 with the top plate 12 and the bottom plate 13. In some embodiments, surfaces of the fitting piece 122 of the peripheral side 121 of the top plate 12 and surfaces of the fitting piece 1124 of the second side wall unit 112 have shapes matching each other. In some embodiments, surfaces of the fitting piece 132 of the peripheral side 131 of the bottom plate 13 and the fitting piece 1123 of the second side wall unit 112 have shapes matching each other.

In some embodiments, the fitting piece 122 and the fitting piece 132 are an extrusion, and preferably an aluminum extrusion. In some embodiments, the extrusion may be made of metal, such as stainless steel, iron or alloy. In some embodiments, the extrusion may be made of polymer, such as plastic, rubber or silicone.

In some embodiments, cross sections of the fitting piece 122 of the top plate 12 and the fitting piece 1114 of the first side wall unit 111 may have male and female shapes compatible with each other. In some embodiments, cross sections of the fitting piece 122 of the top plate 12 and the fitting piece 1124 of the second side wall unit 112 may have male and female shapes compatible with each other.

In some embodiments, cross sections of the fitting piece 132 of the bottom plate 13 and the fitting piece 1113 of the first side wall unit 111 may have male and female shapes compatible with each other. Cross sections of the fitting piece 132 of the bottom plate 13 and the fitting piece 1123 of the second side wall unit 112 may have male and female shapes compatible with each other.

In the embodiment of the present disclosure, a surface where any two members of the cabinet unit 1 are in contact or connected with or abut against each other is defined by a fitting piece (e.g., an extrusion), so that there is a close fitting interface between the two surfaces. In some embodiments, the fitting piece is not limited to having a fixed cross-sectional shape. However, in most cases, the extrusion has the advantages of being easier to reproduce in large quantities.

In some embodiments, the interface defined by any two fitting pieces fitted with each other may be provided with a sealing piece 50. In some embodiments, the sealing piece 50 may be a waterproof strip, which may be made of silicone, rubber or plastic, so that the interface of the two fitting pieces is air-tight and water-tight, and the friction or vibration between the two fitting pieces is reduced.

In some embodiments, a plurality of nuts 123 and 133 are embedded in the peripheral sides 121 and 131 of the top plate 12 and the bottom plate 13. The nuts 123 and 133 are embedded on inner sides of the fitting pieces 122 and 132 of the top plate 12 and the bottom plate 13, and the fitting pieces 122 and 132 of the top plate 12 and the bottom plate 13 have openings such that openings of the nuts 132 and 133 are exposed outside.

Referring to FIG. 7, in some embodiments, the side surface of the first side wall unit 111 facing the top plate 12 has a aperture 1116, which runs through the fitting piece 1114 so as to allow a bolt to pass through and to be connected to the nut 133 of the top plate 12. Referring to FIG. 12, in some embodiments, the side surface of the first side wall unit 111 facing the bottom plate 13 has a aperture 1116, which runs through the fitting piece 1113 so as to allow a bolt to pass through and to be connected to the nut 133 of the bottom plate 13.

Referring to FIG. 7, in some embodiments, the side surface of the second side wall unit 112 facing the top plate 12 has a aperture 1126, which runs through the fitting piece 1124 so as to allow a bolt to pass through and to be connected to the nut 123 of the top plate 12. Referring to FIG. 12, in some embodiments, the side surface of the second side wall unit 112 facing the bottom plate 13 has a aperture 1126, which runs through the fitting piece 1123 so as to allow a bolt to pass through and to be connected to the nut 133 of the bottom plate 13.

In some embodiments, the fitting pieces 1113 and 1114 of the first side wall unit 111 may also be connected to the fitting pieces 122 and 132 of the top plate 12 and the bottom plate 13 by other connection methods such as welding, riveting and bonding. In some embodiments, the fitting pieces 1123 and 1124 of the second side wall unit 112 may also be connected to the fitting pieces 122 and 132 of the top plate 12 and the bottom plate 13 by other connection methods such as welding, riveting and bonding.

Referring to FIG. 2 and FIG. 9, a detailed assembly method of the door 14 of the cabinet unit 1 of the present disclosure will be described below. In some embodiments, the vertical outer side surface of the second side wall unit 112 has a fitting piece 1125. In some embodiments, two rows of nuts are embedded in the inner side of the fitting piece 1125, and the fitting piece 1125 has openings such that openings of the nuts are exposed outside. In some embodiments, a plurality of connectors 15 are provided. Each connector has a hole, which allows a bolt to pass through and to be connected to the nut so as to fix the connector 15 to the fitting piece 1125.

Referring to FIG. 7, the first side wall unit 111 and door 14 are connected by the same method as described above. In some embodiments, the vertical outer side surface of the first side wall unit 111 has a fitting piece 1115. In some embodiments, two rows of nuts 123 are embedded in the inner side of the fitting piece 1115, and the fitting piece 1115 has openings such that openings of the nuts 123 are exposed outside. In some embodiments, a plurality of connectors 15 are provided. Each connector has a hole, which allows a bolt to pass through and to be connected to the nut 123 so as to fix the connector 15 to the fitting piece 1125.

In some embodiments, the hinge 141 is fixed to the connector 15 by welding, screwing or riveting, and the door 14 is fixed to the hinge 141. In some embodiments, two opposite side surfaces of the cabinet unit 1 have the doors 14. In some embodiments, the door 14 on each side surface of the cabinet unit 1 includes double door leaves, and each door leaf is connected to the corresponding side wall 11 by the same method as described above.

According to the above, the cabinet unit 1 of the present disclosure may be constructed by assembly, which thus can enhance the mobility of the cabinet unit 1.

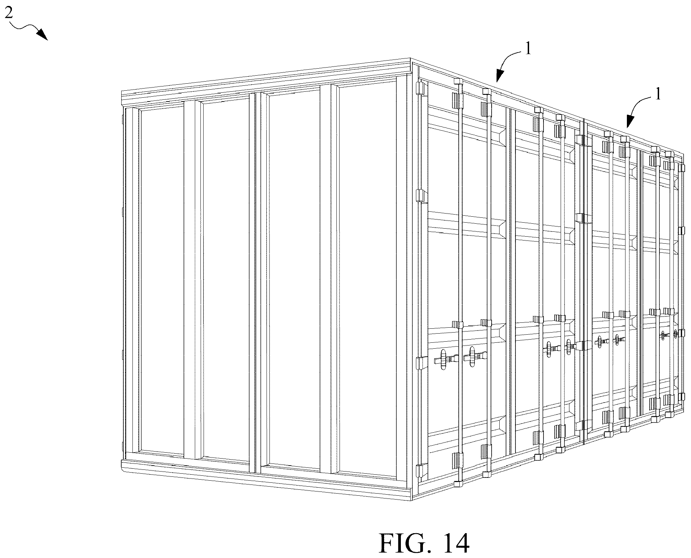

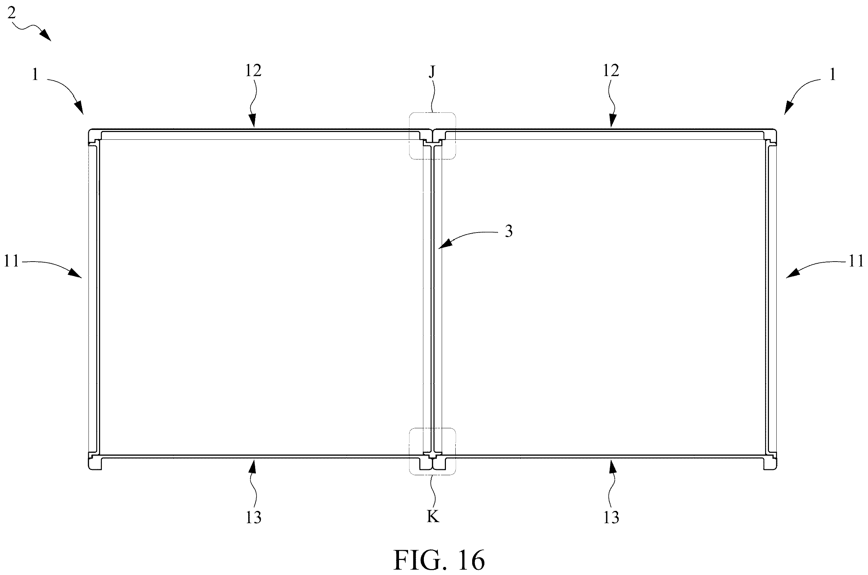

Referring to FIG. 14 to FIG. 16, a detailed structure of a cabinet system 2 of the present disclosure will be described below. In some embodiments, the cabinet system 2 is formed by combining at least two cabinet units 1. In some embodiments, the cabinet system 2 may be formed by connecting a plurality of cabinet units 1 in series, so that the cabinet system 2 of the present disclosure can be assembled on site. Besides, a number of the cabinet units 1 of the cabinet system 2 of the present disclosure may be increased or decreased at any time according to needs.

In some embodiments, side walls on a periphery of the cabinet system 2 have the same structure as side walls 11 of the cabinet unit 1, and there are middle walls 3. In some embodiments, the middle wall 3 is substantially rectangular. In some embodiments, the middle wall 3 is arranged on peripheral sides of the lower surface of a top plate 12 and the upper surface of a bottom plate 11 of each of two adjacent cabinet units 1. In some embodiments, the middle wall 3 is connected to the top plates 12 of both of the two adjacent cabinet units 1, and connected to the bottom plates 13 of both of the two adjacent cabinet units 1, so that the two adjacent cabinet units 1 share the middle wall 3.

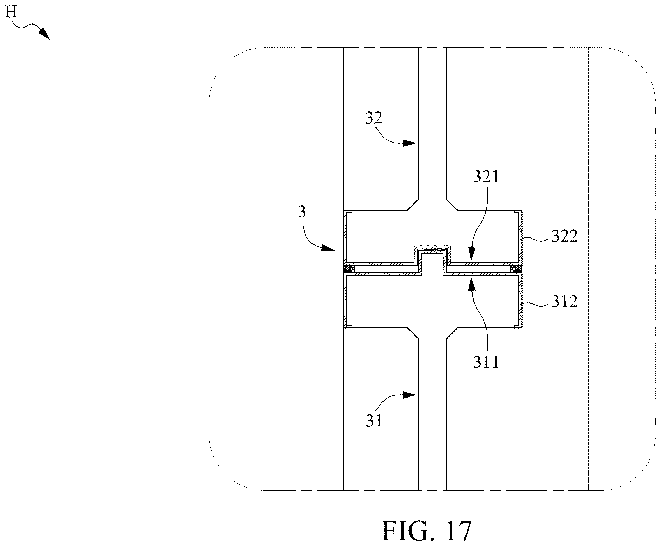

In some embodiments, the middle wall 3 is formed by combining at least two side wall units. Referring to FIG. 17, in some embodiments, the middle wall 3 is formed by combining a third side wall unit 31 (also referred to as a first side wall unit of the middle wall 3) and a fourth side wall unit 32 (also referred to as a second side wall unit of the middle wall 3).

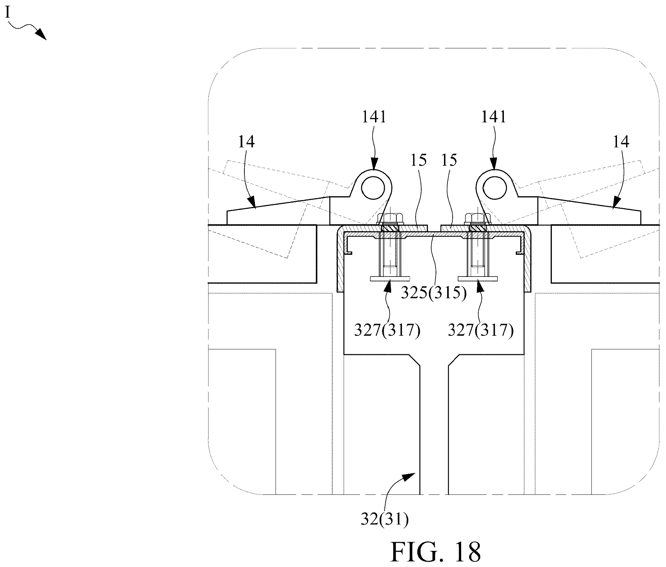

Referring to FIG. 18, in some embodiments, left and right sides of a side surface of the middle wall 3 of the cabinet system 2 are respectively provided with a plurality of connectors 15 along a vertical direction. In some embodiments, the connector 15 is provided with a hinge 141. In some embodiments, a door 14 is a double-leaf door, and a side surface of each door leaf is connected to the hinge 141.

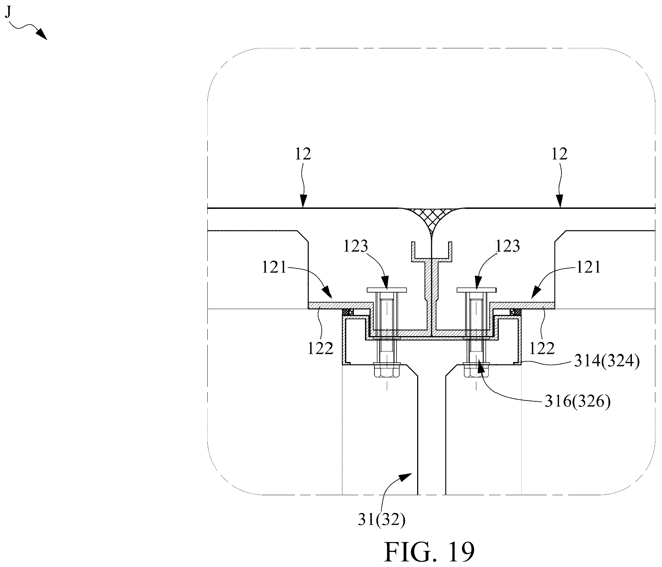

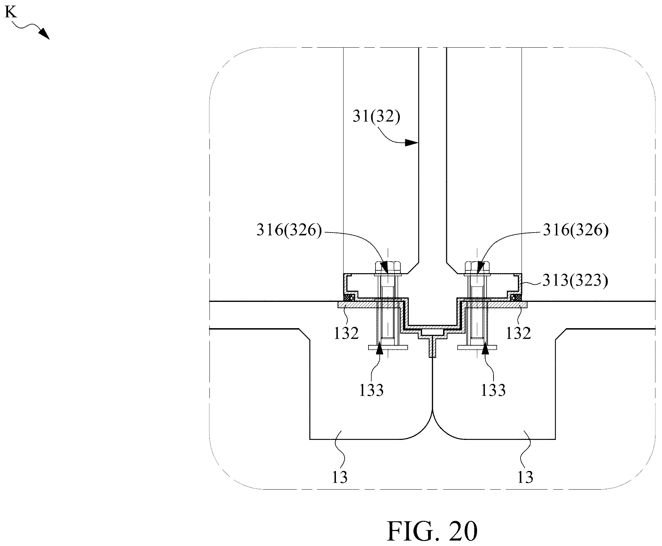

FIG. 14 to FIG. 16 are partially enlarged views of the cabinet system 2 in FIG. 17 to FIG. 20. Detailed connection methods of the middle wall 3 of the cabinet system 2 of the present disclosure with the top plates 12, the bottom plates 13 and the doors 14 of the adjacent cabinet units 1 will be described below. Referring to FIG. 17, in some embodiments, the third side wall unit 31 of the middle wall 3 has a third fitting piece 312 on the third side surface 311. Referring to FIG. 20, a side surface of the third side wall unit 31 facing the bottom plate 13 has a fitting piece 313. Referring to FIG. 19, a side surface of the third side wall unit 31 facing the top plate 12 has a fitting piece 314. Referring to FIG. 18, a vertical outer side surface of the third side wall unit 31 has a fitting piece 315.

Referring to FIG. 17, the fourth side wall unit 32 has a third fitting piece 322 on the fourth side surface 321. Referring to FIG. 20, a side surface of the fourth side wall unit 32 facing the bottom plate 13 has a fitting piece 323. Referring to FIG. 19, a side surface of the fourth side wall unit 32 facing the top plate 12 has a fitting piece 324. Referring to FIG. 18, a vertical outer side surface of the fourth side wall unit 32 has a fitting piece 325.

Referring to FIG. 19 and FIG. 20, in some embodiments, cross sections of the fitting pieces 313 and 314 of the third side wall unit 31 and the fitting pieces 323 and 324 of the fourth side wall unit 32 have a left-right symmetrical shape.

In some embodiments, the third side wall unit 31 and the fourth side wall unit 32 are made by concrete grouting. The third fitting piece 312 and the fitting pieces 313 to 315 of the third side wall unit 31 and the second fitting piece 322 and the fitting pieces 323 to 325 of the fourth side wall unit 32 are used as a part of a molding plate for concrete grouting. In some embodiments, after the concrete is poured and solidifies, the third fitting piece 312 and the fitting pieces 313 to 315 of the third side wall unit 31 and the second fitting piece 322 and the fitting pieces 323 to 325 of the fourth side wall unit 32 are not removed but left on the surfaces of the third side wall unit 31 and the fourth side wall unit 32, so that the third side surface 311 of the third side wall unit 31 is defined by the third fitting piece 312, and the fourth side surface 321 of the fourth side wall unit 32 is defined by the fourth fitting piece 322. In some embodiments, the fitting pieces 313 to 315 and 323 to 325 of the third side wall unit 31 and the fourth side wall unit 32 define their corresponding side surfaces.

In some embodiments, the third fitting piece 312, the fourth fitting piece 322 and the fitting pieces 313 to 315 and 323 to 325 are an extrusion, and preferably an aluminum extrusion. In some embodiments, the extrusion may be made of metal, such as stainless steel, iron or alloy. In some embodiments, the extrusion may be made of polymer, such as plastic, rubber or silicone.

Referring to FIG. 17, the third fitting piece 312 of the third side wall unit 31 fits the fourth fitting piece 322 of the fourth side wall unit 32. In some embodiments, the third fitting piece 312 of the third side wall unit 31 and the fourth fitting piece 322 of the fourth side wall unit 32 are configured to form a snap fit with each other. In some embodiments, the third fitting piece 312 of the third side wall unit 31 and the fourth fitting piece 322 of the fourth side wall unit 32 may also be connected to each other by welding, screwing, riveting or bonding. In some embodiments, a cross section of the third fitting piece 312 has a male shape. A cross section of the fourth fitting piece 322 has a male shape compatible with the female shape. In some embodiments, the cross section of the third fitting piece 312 has a female shape. The cross section of the fourth fitting piece 322 has a male shape fitted with the female shape.

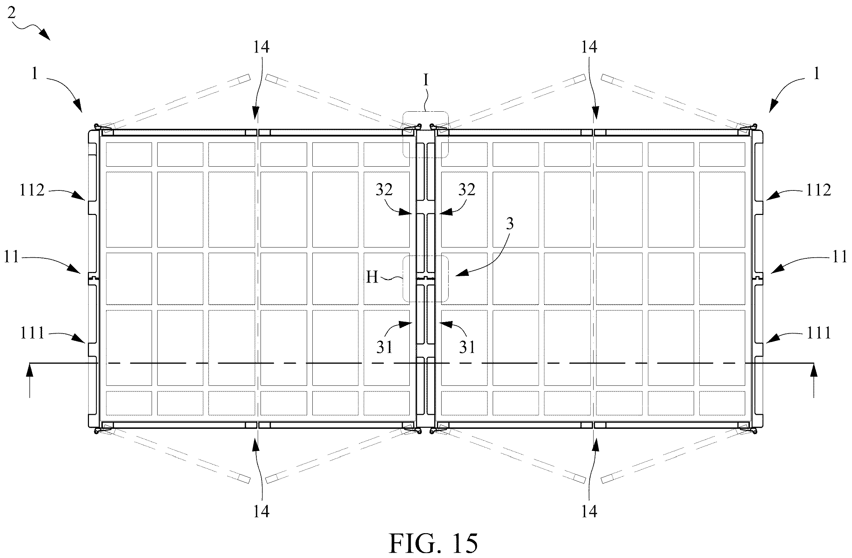

Referring to FIG. 15 and FIG. 17, the middle wall 3 is formed by the third fitting piece 312 of the third side wall unit 31 and the fourth fitting piece 322 of the fourth side wall unit 32 abutting against each other. In some embodiments, the male shape of the cross section of the third fitting piece 312 fits with the female shape of the cross section of the fourth fitting piece 322 to form the middle wall 3.

Referring to FIG. 19, in some embodiments, the fitting piece 122 on the peripheral side 121 of the top plate 12 of the cabinet unit 1 on the left and a left half of the fitting piece 314 of the third side wall unit 31 have shapes compatible with each other. The fitting piece 122 on the peripheral side 121 of the top plate 12 of the cabinet unit 1 on the right and a right half of the fitting piece 314 of the third side wall unit 31 have shapes compatible with each other. In this way, the fitting pieces 122 of the top plates 12 of the two adjacent cabinet units 1 are jointly fitted with the fitting piece 314 of the third side wall unit 31.

Referring to FIG. 20, in some embodiments, the fitting piece 132 on the peripheral side 131 of the bottom plate 13 of the cabinet unit 1 on the left and a left half of the fitting piece 313 of the third side wall unit 31 have shapes compatible with each other. The fitting piece 132 on the peripheral side 131 of the bottom plate 13 of the cabinet unit 1 on the right and a right half of the fitting piece 313 of the third side wall unit 31 have shapes compatible with each other. In this way, the fitting pieces 132 of the bottom plates 13 of the two adjacent cabinet units 1 are jointly fitted with the fitting piece 313 of the third side wall unit 31.

The structures shown in FIG. 19 and FIG. 20 may also show the relative position between the fourth side wall unit 32, and the top plates 12 and the bottom plates 13 of the two adjacent cabinet units 1.

Referring to FIG. 19, in some embodiments, cross sections of the fitting pieces 122 of the top plates 12 and the fitting piece 314 of the third side wall unit 31 may have male and female shapes compatible with each other. Referring to FIG. 19, in some embodiments, cross sections of the fitting pieces 122 of the top plates 12 and the fitting piece 324 of the fourth side wall unit 32 may have male and female shapes compatible with each other.

Referring to FIG. 20, in some embodiments, cross sections of the fitting pieces 132 of the bottom plates 13 and the fitting piece 313 of the third side wall unit 31 may have male and female shapes compatible with each other. Referring to FIG. 20, cross sections of the fitting pieces 132 of the bottom plates 13 and the fitting piece 323 of the fourth side wall unit 32 may have male and female shapes compatible with each other.

In the embodiment of the present disclosure, a surface where any two members of the cabinet system 2 are in contact or connected with or abut against each other is defined by a fitting piece (e.g., an extrusion), so that there is a close fitting interface between the two surfaces. In some embodiments, the fitting piece is not limited to having a particular cross-sectional shape. However, in most cases, the extrusion has the advantages of being easier to be repeatedly manufactured in large quantities.

In some embodiments, the interface defined by any two fitting pieces compatible with each other may be provided with a sealing piece 50. In some embodiments, the sealing piece 50 may be a waterproof strip, which may be made of silicone, rubber or plastic, so that the interface of the two fitting pieces is air-tight and water-tight, and the friction or vibration between the two fitting pieces is reduced.

Referring to FIG. 19, in some embodiments, the side surface of the third side wall unit 31 facing the top plate 12 has two rows of apertures 316, which run through the fitting piece 314 to allow bolts to pass through and to be connected to the nuts 123 on the top plates 12 of the adjacent two cabinet units 1. Referring to FIG. 20, in some embodiments, the side surface of the third side wall unit 31 facing the bottom plate 13 has two rows of apertures 316, which run through the fitting piece 313 to allow bolts to pass through and to be connected to the nuts 133 on the bottom plates 13.

Referring to FIG. 19, in some embodiments, the side surface of the fourth side wall unit 32 facing the top plate 12 has two rows of apertures 326, which run through the fitting piece 324 to allow bolts to pass through and to be connected to the nuts 123 of the top plates 12. Referring to FIG. 20, in some embodiments, the side surface of the fourth side wall unit 32 facing the bottom plate 13 has two rows of apertures 326, which run through the fitting piece 323 to allow bolts to pass through and to be connected to the nuts 133 on the bottom plates 13.

In some embodiments, the fitting pieces 313 and 314 of the third side wall unit 31 may also be connected to the fitting pieces 122 and 132 of the top plate 12 and the bottom plate 13 by other connection methods such as welding, riveting and bonding. In some embodiments, the fitting pieces 323 and 324 of the fourth side wall unit 32 may also be connected to the fitting pieces 122 and 132 of the top plate 12 and the bottom plate 13 by other connection methods such as welding, riveting and bonding.

Referring to FIG. 15 and FIG. 18, a detailed assembly method of the door 14 of the cabinet system 2 of the present disclosure is described below. In some embodiments, the vertical outer side surface of the fourth side wall unit 32 has a fitting piece 325. In some embodiments, two rows of nuts 327 are embedded in the inner side of the fitting piece 325, and the fitting piece 325 has openings such that openings of the nuts 327 are exposed outside. In some embodiments, a plurality of connectors 15 are provided. Each connector has a hole, which allows a bolt to pass through and to be connected to the nut 327 so as to fix the connector 15 to the fitting piece 325. In some embodiments, the hinge 141 is fixed to the connector 15 by welding, screwing or riveting, and the door 14 is fixed to the hinge 141.

Referring to FIG. 18, in some embodiments, the vertical outer side surface of the third side wall unit 31 has a fitting piece 315. In some embodiments, two rows of nuts 317 are embedded in the inner side of the fitting piece 315, and the fitting piece 315 has openings such that openings of the nuts 317 are exposed outside. In some embodiments, a plurality of connectors 15 are provided. Each connector has a hole, which allows a bolt to pass through and to be connected to the nut 317 so as to fix the connector 15 to the fitting piece 315. In some embodiments, the hinge 141 is fixed to the connector 15 by welding, screwing or riveting, and the door 14 is fixed to the hinge 141.

According to the above, the cabinet unit 1 and cabinet system 2 constructed thereby according to the present disclosure at least include a first member and a second member. The first member has a first side surface, and the second member has a second side surface. In some embodiments, the first side surface of the first member has the first fitting piece. The second side surface of the second member has the second fitting piece. In some embodiments, the first side surface of the first member is defined by the first fitting piece. The second side surface of the second member is defined by the second fitting piece. In some embodiments, the first fitting piece of the first member and the second fitting piece of the second member are configured to fit with each another. In some embodiments, the first member and the second member may be a whole or a part of the side wall 11, the top plate 12 or the bottom plate 13 of the cabinet unit 1 in the embodiments of the present disclosure. In some embodiments, the first member and the second member may be a whole or a part of the middle wall 3 of the cabinet system 2 in the embodiments of the present disclosure. In some embodiments, the first member and the second member are made of ultra-high performance concrete (UHPC).

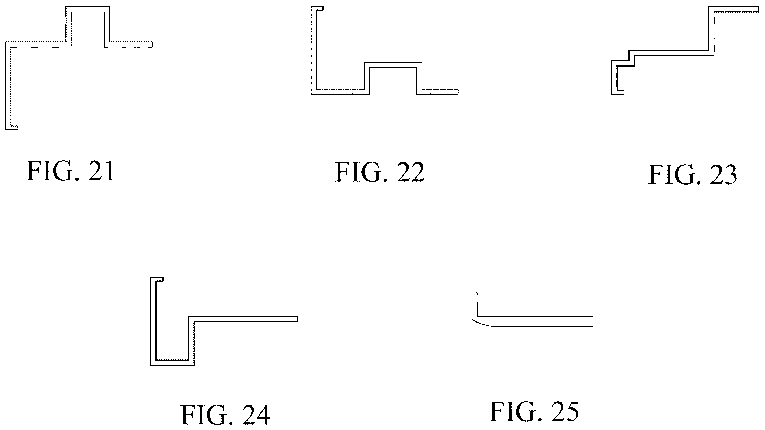

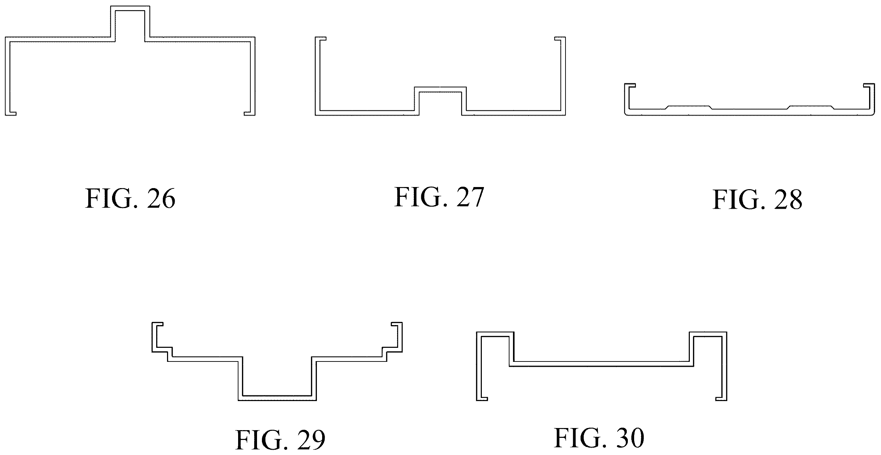

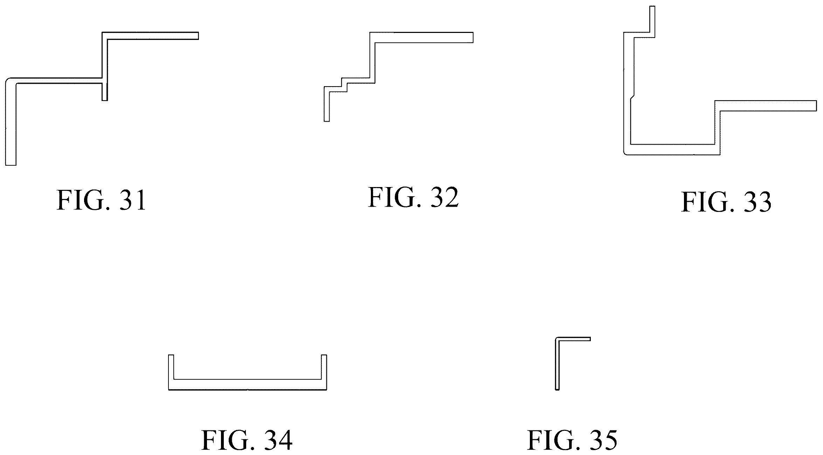

In some embodiments, the fitting piece may have multiple cross-sectional shapes as shown in FIG. 21 to FIG. 35 to meet the actual needs.

In some embodiments, the side wall 11 (including the first side wall unit 111 and the second side wall unit 112), the top plate 12 and the bottom plate 13 of the cabinet unit 1, and the middle wall 3 (including the third side wall unit 31 and the fourth side wall unit 32) of the cabinet system 2 have concrete bodies. In some embodiments, the concrete bodies may include synthetic fibers. In some embodiments, a length of the synthetic fibers is about 4 mm to about 20 mm, and a diameter of the synthetic fibers is about 0.2 mm. In some embodiments, a content of the synthetic fibers in the concrete body is about 30 kg/m³ to about 60 kg/m³. The synthetic fibers may increase a bending strength of the concrete body. In some embodiments, the concrete body is formed by ultra-high performance concrete (UHPC).

According to some embodiments of the present disclosure, since the concrete body includes the aforementioned synthetic fibers and/or is formed by UHPC, there is no need to arrange a reinforcement structure (e.g., reinforcement cage and/or reinforcement component including multiple hoops) in a wall of the concrete body, and the concrete body itself can have bending resistance similar to ordinary reinforced concrete. In addition, since there is no need to arrange the reinforcement structure for increasing the bending strength in the concrete body, the concrete body can have a small wall thickness, so that the weight of the side wall units of the cabinet unit 1 and the cabinet system 2 can be reduced, which is beneficial to transportation and movement of the side wall units and can increase the assembly speed of the cabinet unit 1 and the cabinet system 2.

In some embodiments, the concrete body may further include one or two or more types of cement having different ingredients, multiple different granular materials, oxides and multiple different additives. In some embodiments, the concrete body may include Portland cement, silica fume (which has a size characterized by powder), silica sand (which has a size or particle size of smaller than about 2 cm), quartz powder (which has a size or particle size of about 20 mm to about 30 mm), a water reducing agent, a defoamer, an expansion agent, or any combination of the above.

In some embodiments, the concrete body may include one or more of Portland cement type I, Portland cement type II, Portland cement type III, Portland cement type IV and Portland cement type V in a content of about 800 kg/m³ to about 900 kg/m³. In some embodiments, the concrete body may include one of Portland cement type I, Portland cement type II, Portland cement type III, Portland cement type IV and Portland cement type V in a content of about 400 kg/m³ to about 500 kg/m³, and another of Portland cement type I, Portland cement type II, Portland cement type III, Portland cement type IV and Portland cement type V in a content of about 400 kg/m³ to about 500 kg/m³. In some embodiments, the concrete body may include the silica fume in a content of about 120 kg/m³ to about 180 kg/m³. In some embodiments, the concrete body may include the silica sand in a content of about 900 kg/m³ to about 1000 kg/m³. In some embodiments, the concrete body may include the quartz powder in a content of about 30 kg/m³ to about 150 kg/m³. In some embodiments, due to the combination of the silica fume and the quartz powder, the concrete body has higher compressive strength than ordinary concrete. In some embodiments, the addition of the oxides can be used for adjusting the color of the appearance of the concrete body.

In some embodiments, the concrete body may include the water reducing agent in a content of about 10 kg/m³ to about 20 kg/m³. In some embodiments, the concrete body may include the expansion agent in a content of equal to or smaller than about 10 kg/m³ and equal to or smaller than about 25 kg/m³.

In some embodiments, a unit structural weight of the concrete body is equal to or greater than about 2300 kg/m³. In some embodiments, the unit structural weight of the concrete body is about 2300 kg/m³ to about 2700 kg/m³. In some embodiments, the compressive strength of the concrete body is equal to or greater than about 120 MPa. In some embodiments, the compressive strength of the concrete body is about 120 MPa to about 180 MPa. In some embodiments, an ultimate bending strength of the concrete body is greater than about 15 MPa. In this way, there is no need to arrange the reinforcement cage and/or the reinforcement component including multiple hoops for improving the bending strength in the concrete body, so that the concrete body can have a small wall thickness, which thereby can reduce the overall weight of the cabinet unit 1 and the cabinet system 2. Besides, the concrete body can provide high compressive strength and high bending strength for the cabinet unit 1 and the cabinet system 2, and thus, can still maintain the completeness of the overall structure when applied to an extreme environment (e.g., a high-temperature flame environment).

In some embodiments, a thermal conductivity of the concrete body is equal to or smaller than about 1.8 W/m·K. In some embodiments, the thermal conductivity of the concrete body is about 1.6 W/m·K to about 1.8 W/m·K. Compared with metal materials or ordinary concrete (which has a thermal conductivity of about 1.9 W/m·K to about 2.1 W/m·K), the concrete body of the present disclosure has a better thermal insulation effect, which is beneficial to slowing down the heat conduction between the inside of the accommodating space S1 and the outside of the concrete body. When apparatuses or components in the accommodating space S1 need to be maintained at a specific high or low temperature, the good thermal insulation effect of the concrete body is beneficial to reducing the energy required by air conditioning devices, which can reduce the cost and has additional effects of environmental protection, energy saving and carbon reduction.

One or more inner surfaces of the side wall 11 of the cabinet unit 1 or the middle wall 3 of the cabinet system 2 may be provided with a flame-resistant material layer (not shown). In some embodiments, the flame-resistant material layer directly contacts a plurality of inner surfaces of the concrete body. In some embodiments, the flame-resistant material layer includes a ceramic fiber board, a ceramic fiber blanket, insulating firebricks or any combination thereof. In some embodiments, the flame-resistant material layer has a thickness of smaller than or equal to about 5 cm. In some embodiments, the flame-resistant material layer has a thickness of smaller than or equal to about 2.5 cm.

In some embodiments, concrete slurry that has been mixed may be injected into a mold having a predetermined shape, and before the concrete slurry is hardened, the flame-resistant material layer may be attached to the semi-finished product of the concrete slurry and then curing is carried out. In this way, the hardened concrete can be firmly bonded with the flame-resistant material layer, so that the bonding interface between the concrete body and the flame-resistant material layer has high bonding strength, and therefore, the flame-resistant material layer will not fall off due to high heat.

In some embodiments, the cabinet unit 1 may be configured to resist a flame with a temperature of equal to or higher than about 600°C. In some embodiments, the cabinet unit 1 is configured to resist a flame with a temperature of equal to or higher than about 900°C. In some embodiments, the cabinet unit 1 is configured to resist a flame with a temperature of equal to or higher than about 900°C to about 1200°C. In some embodiments, a whole of the concrete body and the flame-resistant material layer is configured to resist a flame with a temperature of equal to or higher than about 600°C. In some embodiments, the whole of the concrete body and the flame-resistant material layer is configured to resist a flame with a temperature of equal to or higher than about 900°C. In some embodiments, the whole of the concrete body and the flame-resistant material layer is configured to resist a flame with a temperature of equal to or higher than about 900°C to about 1200°C.

The cabinet unit 1 may further include a flame-retardant adhesive layer (not shown). In some embodiments, the flame-retardant adhesive layer may be arranged between the concrete body and the flame-resistant material layer. In some embodiments, the flame-resistant material layer includes a ceramic fiber board, a ceramic fiber blanket, insulating firebricks or any combination thereof, and the flame-retardant adhesive layer includes refractory clay. In some embodiments, the refractory clay includes an aluminum matrix material.

In some embodiments, concrete slurry that has been mixed may be injected into a mold having a predetermined shape, and then cured, and the mold is removed to make the concrete body or a local structural component (e.g., a wall) of the concrete body. Next, the surface of the concrete body is coated with the flame-retardant adhesive layer, the flame-resistant material layer is attached to the flame-retardant adhesive layer, and then curing is carried out. In some embodiments, the curing at this stage is carried out at a temperature of about 25°C to 105°C for about 1 to 7 days. In this way, after the completion of the curing, the flame-retardant adhesive layer (e.g., after heated) will form chemical bonds between the concrete body and the flame-resistant material layer, so that the concrete body and the flame-resistant material layer can be tightly bonded without delamination.

In some embodiments, the cabinet unit 1 is configured to accommodate at least one battery system (not shown). In some embodiments, the battery system may include a plurality of battery packs, and each battery pack may include a plurality of battery modules. In some embodiments, the battery system may include an accommodating case, and the battery packs are arranged in the accommodating case.

When the battery (e.g., lithium battery) in the battery pack is charged and discharged, lithium ions may puncture the separator in the battery due to various factors (e.g., overcharge, impact, electronic control system error, operating environment or process defects), so that the cathode comes into contact with the anode to form a short circuit, which may result in a high-temperature chemical reaction and thus ignite combustible organic constituents in the battery. Thermal runaway of the lithium battery may generate a high temperature of up to 600°C to 1000°C or even higher. When heat energy diffuses from the ignited battery to the surrounding area, cells of other adjacent batteries will also heat up. When the allowable temperature (e.g., the allowable temperature of the lithium battery is about 150°C) of the cells is exceeded, the adjacent heated cells will also give off heat, which will cause the electronic group and even the battery system to burn completely. Moreover, the combustion of the cathode material inside the battery comes from the chemical reaction of the internal materials, thus leading to the persistence of the flame, which may have a temperature of up to 600°C to 1000°C.

According to some embodiments of the present disclosure, the cabinet unit 1 including a composite structure of the concrete body and the flame-resistant material layer can effectively limit the high temperature generated by the thermal runaway of the lithium battery in the cabinet unit 1, and the fire accident caused by flame propagation can be prevented only by injecting water into the cabinet unit 1. Moreover, since the high temperature generated by the thermal runaway of the lithium battery can be limited in the cabinet unit 1, the flame will not spread to the outside of the cabinet unit 1, causing flame propagation, which can make the process of disaster relief more convenient and safer.

In addition, when the traditional metal container is used as the energy storage cabinet, the metal subjected to high temperature is prone to deformation, distortion and bending, which leads to the collapse of the metal container and spreading of flame to the outside, making the fire propagation uncontrollable. In contrast, according to some embodiments of the present disclosure, the concrete body of the cabinet unit 1 has high compressive strength and high bending strength, so that the composite structure of the concrete body and the flame-resistant material layer will not become softened or deformed to collapse even in a high-temperature environment, which can make the process of disaster relief more convenient and safer. Furthermore, the concrete body of the present disclosure can provide sufficient structural strength for the cabinet unit 1 without embedding reinforcements or only by embedding a small number of reinforcement bars. Compared with the traditional reinforced concrete, the cabinet unit 1 of the present disclosure can be lighter in weight, easier to assemble and convenient to move and transport.

The following presents some embodiments according to the present disclosure, which are used to further present experimental results of exemplary embodiments of the characteristics and advantages of the concrete body for movable cabinets. Table 1 shows experimental conditions of Embodiments E1, E2, E3, E4 and C1, and Table 2 shows test results of Embodiments E1, E2, E3 and E4. "Cement I" and "cement II" are selected from two of Portland cement type I, Portland cement type II, Portland cement type III, Portland cement type IV and Portland cement type V. "Granular material 1" is silica fume. "Granular material 2" is quartz powder. "Granular material 3" is silica sand. "Additive 1" is a water reducing agent. "Additive 2" is a defoamer. "Additive 3" is an expansion agent.

**Table 1**

| | Cement I | Cement II | Synthetic fibers | | | Granular material 1 | Granular material 2 | Granular material 3 | Oxides | Additive 1 | Additive 2 | Additive 3 |
|---|---|---|---|---|---|---|---|---|---|---|---|---|
| | kg/m³ | kg/m³ | Length (mm) | Diameter (mm) | kg/m³ | kg/m³ | kg/m³ | kg/m³ | kg/m³ | kg/m³ | kg/m³ | kg/m³ |
| E1 | 800∼900 | 0 | 4∼20 | 0.2 | 30∼60 | 120∼180 | 120∼150 | 900∼1000 | 0∼70 | 10∼20 | 0∼10 | 0∼25 |
| E2 | 400∼500 | 400∼500 | | | | | 80∼120 | | | | | |
| E3 | 400∼500 | 400∼500 | | | | | 30∼60 | | | | | |
| E4 | 400∼500 | 400∼500 | | | | | 50∼90 | | | | | |
| C1 | 200∼00 | - | - | - | - | - | - | 600∼800 | - | 2∼5 | - | - |
| C2 | 350∼500 | - | - | - | - | - | - | 800∼1000 | - | 4∼8 | - | - |

The cement, the granular materials, the oxides and the additives in the embodiments shown in Table 1 are mixed with water in proportion, and stirred for several minutes until the slurry becomes uniform and pasty. Then, the synthetic fibers are added, and the resulting slurry is stirred uniformly and injected into a mold. Next, curing is carried out at a temperature of 22°C to 24°C and a humidity of 50 to 95% for 3 days, and the mold is removed. After 28 days, the finished products should be tested for their mechanical properties. The test results are shown in Table 2.

**Table 2**

| | Unit weight (kg/m³) | Compressive strength (MPa) | Ultimate bending strength (MPa) | First crack bending strength (MPa) | Coefficient of elasticity (GPa) | Tensile strength (MPa) | Shrinkage (mm/m) | Diffusion coefficient of chlorine ion (m²/sec) | Thermal conductivity (W/m·K) |
|---|---|---|---|---|---|---|---|---|---|
| E1 | 2300 | 120 | ≥15 | ≥10 | ≥35 | > 5 | < 300 | ≤5×10⁻¹³ | 1.60∼1.80 |
| E2 | 2400 | 150 | ≥20 | | | | | | |
| E3 | 2500 | 180 | ≥25 | | | | | | |
| E4 | 2500 | 160 | ≥22 | | | | | | |
| C1 | 2300 | 28 | | | | | | | 1.90∼2.10 |
| C2 | 2400 | 40 | | | | | | | |

According to the results shown in Table 2, it is apparent that the concrete body according to some embodiments of the present disclosure has good mechanical properties as compared with ordinary concrete. The concrete body according to some embodiments of the present disclosure has a unit structural weight of about 2300 kg/m³ to about 2700 kg/m³, a compressive strength of greater than about 120 MPa, and an ultimate bending strength of greater than about 15 MPa. Moreover, the concrete body according to some embodiments of the present disclosure has a first crack bending strength of greater than about 15 MPa, a coefficient of elasticity of greater than about 35 GPa, and a tensile strength of greater than about 5 MPa. In addition, the concrete body according to some embodiments of the present disclosure has a shrinkage of smaller than about 300 mm/m, a diffusion coefficient of chlorine ion of smaller than about 5×10⁻¹³ m²/sec, and a thermal conductivity of about 1.6 W/m·K to about 1.8 W/m·K.

Besides, Table 3 shows a comparison of the concrete body according to some embodiments of the present disclosure and other materials in terms of weight and compressive capacity. The concrete body is Embodiment E3 in Table 1 to Table 2, and the ordinary concrete is Embodiment C1 in Table 1 to Table 2.

**Table 3**

| | Volume | Weight | Compressive strength (MPa) | Height (cm) | Width (cm) |
|---|---|---|---|---|---|
| Concrete body | 40×40×2 cm³ | 8.4 kg | | | |
| Ordinary concrete | 40×40×2 cm³ | 9.3 kg | | | |
| Concrete body | | | 100 | 37 | 32 |
| Prestressed concrete | | | 100 | 70 | 35 |
| Reinforced concrete | | | 100 | 70 | 60 |

According to the results shown in Table 3, it is apparent that the concrete body according to some embodiments of the present disclosure is lighter in weight than the ordinary concrete, which is beneficial to making lighter movable cabinets. Moreover, compared with the prestressed concrete and the reinforced concrete, the concrete body according to some embodiments of the present disclosure has a smaller thickness in a case of the same compressive strength, which thereby is beneficial to making a thinner wall of the concrete body.

In addition, results of a burning test of the movable cabinet according to some embodiments of the present disclosure are as follows. The cabinet unit 1 included the composite structure of the concrete body and the flame-resistant material layer. After the flame-resistant material layer 120 was continuously burned at 1100°C ± 50°C for 1 h, the flame-resistant material layer was not penetrated, and the composite structure of the concrete body and the flame-resistant material layer did not crack or burst. Moreover, after the completion of the burning, the temperature on the back of the concrete body was maintained at about 150°C or less. As can be seen from the results above, the cabinet unit 1 according to some embodiments of the present disclosure has good fire resistance, flame resistance and compressive resistance.

As used herein, the terms "approximately", "substantially", "essentially" and "about" are used to describe and consider small variations. When used in combination with an event or situation, the term may refer to a case in which the event or situation definitely occurs and a situation in which the event or situation very nearly occurs. For example, when used in conjunction with a numerical value, the terms may refer to a variation range that is smaller than or equal to ±10% of the numerical value, such as smaller than or equal to ±5%, smaller than or equal to ±4%, smaller than or equal to ±3%, smaller than or equal to ±2%, smaller than or equal to ±1%, smaller than or equal to ±0.5%, smaller than or equal to ±0.1%, or less than or equal to ±0.05%. For example, if the difference between two values is smaller than or equal to ±10% of the average of the values, such as smaller than or equal to ±5%, smaller than or equal to ±4%, smaller than or equal to ±3%, smaller than or equal to ±2%, smaller than or equal to ±1%, smaller than or equal to ±0.5%, smaller than or equal to ±0.1% or smaller than or equal to ±0.05%, then the two values can be considered as being "substantially" or "about" the same. For example, "substantially" parallel may refer to an angular variation range of smaller than or equal to ±10° with respect to 0°, such as smaller than or equal to ±5°, smaller than or equal to ±4°, smaller than or equal to ±3°, smaller than or equal to ±2°, smaller than or equal to ±1°, smaller than or equal to ±0.5°, smaller than or equal to ±0.1° or smaller than or equal to ±0.05°. For example, "substantially" perpendicular may refer to an angular variation range of smaller than or equal to ±10° with respect to 90°, such as smaller than or equal to ±5°, smaller than or equal to ±4°, smaller than or equal to ±3°, smaller than or equal to ±2°, smaller than or equal to ±1°, smaller than or equal to ±0.5°, smaller than or equal to ±0.1° or smaller than or equal to ±0.05°.

As used herein, the terms "conductive", "electrically conductive" and "electrical conductivity" refer to the ability to transport electric current. Conductive materials generally indicate those materials that exhibit little or no resistance to current flow. A measure of the electrical conductivity is Siemens per meter (S/m). Usually, the conductive material is a material having an electrical conductivity of greater than about 10⁴ S/m (such as at least 10⁵ S/m or at least 10⁶ S/m). The electrical conductivity of the material may sometimes change with temperature. Unless otherwise specified, the electrical conductivity of the material is measured at room temperature.

As used herein, the terms "a/an" and "the" in singular forms may include a plurality of referents unless the context clearly dictates otherwise. In the description of some embodiments, a component arranged "on" or "above" another component may cover the case where the former component is directly on (for example, in physical contact with) the latter component, and the case where one or more intervening components are located between the former component and the latter component.

Although the present disclosure has been described and illustrated with reference to specific embodiments of the present disclosure, such descriptions and illustrations are not intended to limit the present disclosure. It can be clearly understood by those skilled in the art that various changes may be made and equivalent components may be substituted within the embodiments without departing from the true spirit and scope of the present disclosure as defined by the appended claims. The accompanying drawings may not necessarily be drawn to scale. Due to the variables in the manufacturing procedure, there may be differences between the process reproduction in the present disclosure and the actual devices. There may be other embodiments of the present disclosure that are not specifically shown. The specification and accompanying drawings are to be regarded as illustrative rather than restrictive. Modifications can be made to adapt specific situations, materials, material compositions, methods or procedures to the objectives, spirit and scope of the present disclosure. All these modifications are intended to fall within the scope of the appended claims. Although the methods disclosed herein have been described with reference to specific operations performed in a specific order, it can be understood that these operations can be combined, subdivided or reordered to form equivalent methods without departing from the teachings of the present disclosure. Therefore, unless specifically indicated herein, the order and grouping of operations are not limitations to the present disclosure.

## Claims

1. A cabinet unit (1), comprising:
at least one side wall (11), having a first side wall unit (111) and a second side wall unit (112) adjacent to the first side wall unit (111);
wherein a first side surface (1111) of the first side wall unit has a first fitting piece (1112);
a second side surface (1121) of the second side wall unit corresponding to the first side surface of the first side wall unit has a second fitting piece (1122);
the first fitting piece and the second fitting piece are an extrusion; and
the first fitting piece and the second fitting piece are configured to be compatible with one another.

2. The cabinet unit according to claim 1, wherein the first side surface of the first side wall unit is defined by the first fitting piece; and the second side surface of the second side wall unit is defined by the second fitting piece.

3. The cabinet unit according to claim 2, wherein the first fitting piece and the second fitting piece are configured to snap fit with each other.

4. The cabinet unit according to any of the claims 1 to 3, wherein
a cross section of the first fitting piece has a male shape;
a cross section of the second fitting piece has a female shape; and
the male shape is compatible with the female shape.

5. The cabinet unit according to any of the claims 1 to 4, wherein the first side wall unit and the second side wall unit each have a protruding rib.

6. The cabinet unit according to any one of claims 1 to 5, wherein
a number of the at least one side wall is two, each of other side surfaces of the first side wall unit and the second side wall unit of each side wall has a fitting piece; and
the cabinet unit further comprises:
a bottom plate (13), having fitting pieces (132) on two opposite peripheral sides of an upper surface thereof; and
a top plate (12), having fitting pieces (122) on two opposite peripheral sides of a lower surface thereof;
wherein the two side walls respectively correspond to the two opposite peripheral sides of the bottom plate and the top plate, and fitting pieces at tops and bottoms of the first side wall unit and the second side wall unit of each of the two side walls are fixedly connected to the corresponding fitting pieces on the peripheral sides of the bottom plate and the top plate.

7. The cabinet unit according to claim 6, wherein the first side wall unit, the second side wall unit, the bottom plate and the top plate are made of ultra-high performance concrete (UHPC).

8. The cabinet unit according to claim 6 or 7, further comprising:
a connector (15) fixed to the fitting piece on an outer side of the first side wall unit or the fitting piece on an outer side of the second side wall unit of one of the two side walls; and
a door (14) connected to the connector.

9. The cabinet unit according to any of the claims 6 to 8, wherein there is a sealing piece (50) at an interface between the first fitting piece and the second fitting piece and at an interface between any two corresponding fitting pieces.

10. The cabinet unit according to any of the claims 6 to 9, wherein
a plurality of nuts (123) are embedded in each of the bottom plate and the top plate, and the fitting pieces on the two opposite peripheral sides of the bottom plate and the top plate have openings such that openings of the plurality of nuts are exposed outside; and
side surfaces of the first side wall unit and the second side wall unit corresponding to the peripheral sides of the bottom plate and the top plate have apertures so as to allow bolts to pass through and to be connected to the nuts.

11. The cabinet unit according to any of the claims 1 to 10, further comprising:
a middle wall (3) located between the cabinet unit and an adjacent cabinet unit;
the middle wall has:
a third side wall unit (31); and
a fourth side wall unit (32) adjacent to the third side wall unit;
wherein a first side surface of the third side wall unit has a third fitting piece;
a second side surface of the fourth side wall unit corresponding to the first side surface of the third side wall unit has a fourth fitting piece;
the third fitting piece of the third side wall unit and the fourth fitting piece of the fourth side wall unit are an extrusion; and
the third fitting piece of the third side wall unit and the fourth fitting piece of the fourth side wall unit are configured to be fitted with one another.

12. The cabinet unit according to claim 11, wherein the first side surface of the third side wall unit is defined by the third fitting piece; and the second side surface of the fourth side wall unit is defined by the fourth fitting piece.

13. The cabinet unit according to claim 12, wherein the third fitting piece and the fourth fitting piece are configured to form a snap fit with one another.

14. The cabinet unit according to claim 11 or 12, wherein
a cross section of the third fitting piece has a male shape;
a cross section of the fourth fitting piece has a female shape; and
the male shape is compatible with the female shape.

15. The cabinet unit according to any of the claims 11 to 14, wherein the third side wall unit and the fourth side wall unit each have a protruding rib.
